# EUROPÄISCHE PATENTANMELDUNG

(11) **EP 1 478 024 A1**
(43) Veröffentlichungstag der Anmeldung: **17.11.2004**
(21) Anmeldenummer: 03090139.1
(22) Anmeldetag: 15.05.2003
(51) Int. Cl.: H01L 27/00

(54) **Organische Leuchtdiode (OLED) und Display auf Basis von OLEDs**

(71) Anmelder: Samsung SDI Co., Ltd., Suwon-Si, Kyungki-do (KR)
(72) Erfinder: Redecker, Michael, 12305 Berlin (DE); Fischer, Joerg, 13053 Berlin (DE)
(74) Vertreter: Hengelhaupt, Jürgen D., Dipl.-Ing.

(57) **Zusammenfassung**

Die Erfindung betrifft ein Photolumineszenzanzeigeelement (PQD), welches in einem emissiven Modus zur Umwandlung von Signalspannungen in Licht und/oder in einem reemissiven Modus zur Unterdrückung einer Photolumineszenzemission schaltbar ist und ein Display auf Basis von Photolumineszenzanzeigeelementen (PQD).
Es ist Aufgabe der vorliegenden Erfindung, ein Photolumineszenzanzeigeelement (PQD), welches sowohl in einem emissiven Modus als auch in einem reemissiven Modus schaltbar ist, und ein Display auf Basis von Photolumineszenzanzeigeelementen (PQD) anzugeben, welche bei einem reemissiven Betrieb einen sehr geringen Dunkelstrom aufweisen.
Dazu weist ein erfindungsgemäßes Display eine Löcherblockierschicht (7) und/oder eine Elektronenblockierschicht (6) auf, die zwischen der Emitterschicht (4) und einer Elektrodenschicht (2,5) des Displays angeordnet sind, wobei das höchste besetzte Molekülorbital (12) der Löcherblockierschicht (7) energetisch niedriger als das höchste besetzte Molekülorbital (8) der Emitterschicht (4) ist und/oder das niedrigste unbesetzte Molekülorbital (11) der Elektronenblockierschicht (6) energetisch höher als das niedrigste unbesetzte Molekülorbital (9) der Emitterschicht (4) ist. Durch die erfindungsgemäße Ausgestaltung der Energieniveaus der Molekülorbitale (11,12) der Löcherblockierschicht (7) und/oder Elektronenblockierschicht (6) können Barrieren für die unerwünschte Injektion von Ladungsträgern in Rückwärtsrichtung beim reemissiven Betrieb des Displays geschaffen werden.

## Beschreibung

Die Erfindung betrifft ein Photolumineszenzanzeigeelement (PQD), welches in einem emissiven Modus zur Umwandlung von Signalspannungen in Licht und/oder in einem reemissiven Modus zur Unterdrückung einer Photolumineszenzemission schaltbar ist und ein Display auf Basis von Photolumineszenzanzeigeelementen (PQD) sowie ein Verfahren zur Umwandlung von Signalspannungen in optische Bildinformationen.

Flachdisplays auf der Basis organischer Leuchtdioden (OLEDs) zeichnen sich durch hohe Brillianz und weiten Betrachtungswinkel aus. Als selbstemissive Technologie benötigen OLED-Displays keine Hintergrundbeleuchtung und können damit unter Bedingungen mit niedrigem bis mittlerem Umgebungslichtanteil energetisch vorteilhaft eingesetzt werden.

Unter Bedingungen mit einem hohen Anteil an Umgebungslicht, z.B. in direktem Sonnenlicht, muß jedoch überproportional viel Leistung aufgewendet werden, um die benötigte Helligkeit zu erreichen. Zudem sind die benötigten Ströme für die Ansteuerung der emissiven Bauelemente entsprechend hoch. Daher sind bei einem hohen Umgebungslichtanteil reflektive und reemissive Technologien, wie zum Beispiel Flüssigkristallanzeigen, überlegen. Deren Nachteil besteht jedoch darin, daß sie für die Operation unter Bedingungen mit wenig Umgebungslicht eine Hintergrundbeleuchtung (Backlight) benötigen, durch welche sich die baulichen Ausmaße und die Energieaufnahme bei geringem Umgebungslichtanteil überproportional erhöhen.

Bauelemente, die auf der Basis organischer Leuchtdioden sowohl im emissiven als auch im reemissiven Modus betrieben werden können, sind aus DE 100 42 974 A1 bekannt. Ein solches Photolumineszenzanzeigeelement (PQD, Photoluminescence Quenching Device) hat die Struktur ähnlich einer organischen Leuchtdiode und kann im selbstemissiven Modus, d.h. ohne Umgebungslicht, aber auch im reemissiven Modus betrieben werden. Im reemissiven Modus wird die Intensität des Photolumineszenzlichts durch das Anlegen einer Spannung in Sperrichtung des PQD gesteuert. Bei entsprechender Wahl der Kontakt- und Emittermaterialien läßt sich mit den oben beschriebenen Bauelementen der Betrieb sowohl im emissiven als auch im reemissiven (Photolumineszenzlöschungs-) Modus, der so genannte duale Betrieb, realisieren. Vorteilhafterweise wird hierfür kein Backlight benötigt. Voraussetzung für den reemissiven Betrieb ist, dass ausreichend Umgebungslicht absorbiert werden kann. Außerdem ist es erforderlich, sowohl negative als auch positive Steuerspannungen für das Anzeigeelement bereitzustellen.

In der Grundstruktur bestehen Photolumineszenzanzeigeelemente aus einem transparenten, leitfähigen Kontakt, einer Emitterschicht und einem Gegenkontakt. Zur Steuerung der Helligkeit des Anzeigeelementes wird der Metallkontakt positiv gegenüber dem transparenten Kontakt gepolt, was dem Betrieb in Sperrrichtung (reemissiver Betrieb) entspricht. Diese Struktur weist jedoch im reemissiven Betrieb eine Begrenzung hinsichtlich der Leistungsfähigkeit auf, da auch in Sperrrichtung die Injektionsbarrieren endlich sind und infolgedessen merkliche Dunkelströme fließen. Diese Dunkelströme verschlechtern die Energiebilanz, insbesondere bei niedriger Helligkeit des Anzeigeelementes. Zudem müssen für den Metallkontakt unedle Metalle wie Aluminium oder Kalzium eingesetzt werden, welche eine aufwendige Verkapselung zum Schutz vor Korrosion erfordern.

Zur Verbesserung der Energiebilanz von Leuchtdioden sind aus US 5,294,810 und US 6,097,147 Mehrschichtstrukturen bekannt. Diese Strukturen sind auf eine optimale Funktionalität im emissiven Betrieb der Leuchtdiode optimiert, das heißt für eine optimale Injektion von Ladungsträgern. Ebenso sind nach dem Stand der Technik die Anwendung von anorganischen Materialien in organischen Leuchtdioden als Mittel zur Verbesserung der Injektion von Elektronen für den emissiven Betrieb bekannt.

Darüber hinaus ist die Anwendung von Fluoriden und Oxiden von Alkali- und Erdalkalimetallen zur Verbesserung der Elektroneninjektion in EP 1 083 612 beschrieben. Sämtliche nach dem Stand der Technik bekannten Mehrschichtsysteme für organische Leuchtdioden realisieren jedoch lediglich eine günstige Injektion von Elektronen im emissiven Betrieb der organischen Leuchtdiode. Es ist insoweit mit den bekannten Vorrichtungen nicht möglich, eine Reduzierung der Elektroneninjektion für den reemissiven Betrieb einer organischen Leuchtdiode zu erzielen.

Es ist daher Aufgabe der vorliegenden Erfindung, ein Photolumineszenzanzeigeelement (PQD), welches in einem emissiven Modus und/oder in einem reemissiven Modus schaltbar ist, und ein Display auf Basis von Photolumineszenzanzeigeelementen (PQD) anzugeben, welche bei einem reemissiven Betrieb einen sehr geringen Dunkelstrom aufweisen. Hierdurch soll insbesondere die Leistungsfähigkeit des Displays bzw. des PQD bei niedriger Helligkeit erhöht werden.

Diese Aufgabe wird erfindungsgemäß gelöst durch die Merkmale im kennzeichnenden Teil des Anspruchs 1 und des Anspruchs 8 (Vorrichtungsanspruch) sowie des Anspruchs 13 (Verfahrensanspruch) im Zusammenwirken mit den jeweiligen Merkmalen im Oberbegriff. Zweckmäßige Ausgestaltungen der Erfindung sind in den Unteransprüchen enthalten.

Ein besonderer Vorteil der Erfindung besteht in der Reduzierung des Dunkelstroms für Photolumineszenzanzeigeelemente und Displays auf Basis von Photolumineszenzanzeigeelementen im reemissiven Betrieb.

Dazu weist ein erfindungsgemäßes Display eine Löcherblockierschicht und/oder eine Elektronenblockierschicht auf, wobei die Löcherblockierschicht und/oder die Elektronenblockierschicht zwischen der Emitterschicht und einer Elektrodenschicht des Displays angeordnet sind und das höchste besetzte Molekülorbital der Löcherblockierschicht energetisch niedriger als das höchste besetzte Molekülorbital der Emitterschicht ist und/oder das niedrigste unbesetzte Molekülorbital der Elektronenblockierschicht energetisch höher als das niedrigste unbesetzte Molekülorbital der Emitterschicht ist. Durch die erfindungsgemäße Ausgestaltung der Energieniveaus der Molekülorbitale der Löcherblockierschicht und/oder Elektronenblockierschicht können Barrieren für die unerwünschte Injektion von Ladungsträgern in Rückwärtsrichtung beim reemissiven Betrieb des Displays geschaffen werden.

Zur ausreichenden Unterdrückung des unerwünschten Dunkelstromes ist eine gute energetische Anpassung des Leitungsbandes bzw. LUMO (niedrigstes unbesetztes Molekülorbital) der Löcherblockierschicht an das LUMO der Emitterschicht sowie die Anpassung des Valenzbandes bzw. des höchsten besetzten Molekülorbitals (HOMO) der Elektronenblockierschicht an das HOMO der Emitterschicht von Vorteil, so dass in der Emitterschicht während des reemissiven Betriebs erzeugte Ladungsträger ohne Barrieren abfließen können.

In einer bevorzugten Ausführungsvariante entspricht das niedrigste unbesetzte Molekülorbital der Emitterschicht dem niedrigsten unbesetzten Molekülorbital der Löcherblockierschicht und/oder das höchste besetzte Molekülorbital der Elektronenblockierschicht entspricht dem höchsten besetzten Molekülorbital der Emitterschicht, wobei die erste Elektronenschicht (die dem Substrat zugewandte Elektrodenschicht) die Kathode und die zweite Elektrodenschicht (die dem Substrat abgewandte Elektrodenschicht) die Anode beim reemissiven Betrieb und die erste Elektrodenschicht die Anode und die zweite Elektrodenschicht die Kathode beim reemissiven Betrieb des Displays ausbilden. Sind die Energien des Leitungsbandes der Emitterschicht und der Löcherblockierschicht und die Energien des Valenzbandes der Emitterschicht und der Elektronenblockierschicht gleich, ist sowohl emissiver als auch reemissiver Betrieb möglich.

Wird eine Anpassung der Energieniveaus der Löcherblockierschicht, der Emitterschicht und der Elektronenblockierschicht derart durchgeführt, dass die Ladungsträger beim Abfließen (im reemissiven Betrieb) zwar keine Barriere überwinden müssen, jedoch umgekehrt beim Vorwärtsbetrieb (emissiver Betrieb) Barrieren für die Injektion bestehen, ist lediglich der reemissive Betrieb möglich.

In diesem Fall ist die Auswahl der Materialien für den Metallkontakt nicht auf unedle Metalle begrenzt, so dass auch Materialien mit verbesserter Korrosionsbeständigkeit verwendet werden können. Durch diese Freiheit in der Wahl des Elektrodenmaterials können ebenfalls invertierte Schichtstrukturen hergestellt werden, bei denen der transparente Kontakt die Rolle des Metallkontaktes übernimmt und zur Extraktion von Elektronen dient. Der transparente Kontakt wird dann im reemissiven Betrieb positiv gegenüber dem Metallkontakt gepolt, ohne daß eine Ladungsträgerinjektion stattfindet.

Weiterhin muß ein ausreichender energetischer Abstand zwischen HOMO und LUMO (sog. Bandlücke) gewährleistet sein. Um die Barrieren für Ladungsinjektion in Rückwärtsrichtung zu maximieren, muß die Bandlücke sowohl für Elektronenblockierschicht ausreichend als auch für Löcherblockierschicht groß sein. Die entsprechenden Materialien sollten deshalb im sichtbaren Spektralbereich kein Licht absorbieren.

Weiterhin kann es alternativ vorgesehen sein, dass die Löcherblockierschicht und/oder die Elektronenblockierschicht zumindest teilweise eine Elektrodenschicht ausbilden.

Analog zum Display weist ein Photolumineszenzanzeigeelement eine Löcherblockierschicht und/oder eine Elektronenblockierschicht auf, wobei das Valenzband der Löcherblockierschicht energetisch niedriger als das Valenzband des lichtemittierenden Mateials des PQD ist und/oder das Leitungsband der Elektronenblockierschicht energetisch höher als das Leitungsband des lichtemittierenden Materials des PQD ist.

Die Erfindung wird nachstehend anhand eines Ausführungsbeispiels näher erläutert. Es zeigen:
- Figur 1:: ein erfindungsgemäßes Display mit Elektronenblockierschicht und Löcherblockierschicht in schematischer Schnittdarstellung,
- Figur 2:: die energetischen Zustände von Valenzband und Leitungsband der Elektronenblockierschicht, der Emitterschicht und der Löcherblockierschicht in schematischer Darstellung für ein Display, welches sowohl im emissiven als auch im reemissiven Betrieb schaltbar ist,
- Figur 3:: die energetischen Zustände von Valenzband und Leitungsband der Elektronenblockierschicht, der Emitterschicht und der Löcherblockierschicht in schematischer Darstellung für ein Display, welches im reemissiven Betrieb schaltbar ist und
- Figur 4:: ein erfindungsgemäßes Display mit einer Löcherblockierschicht auf anorganischer Basis in schematischer Schnittdarstellung.

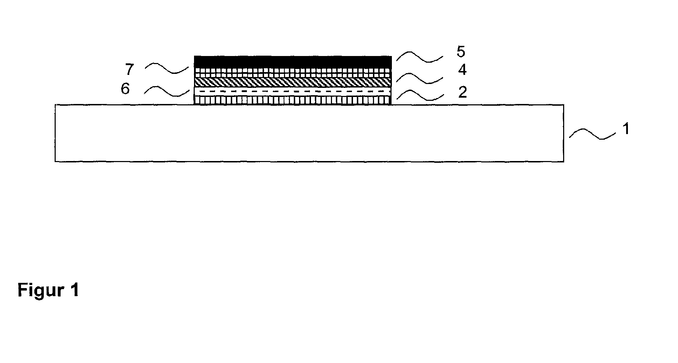

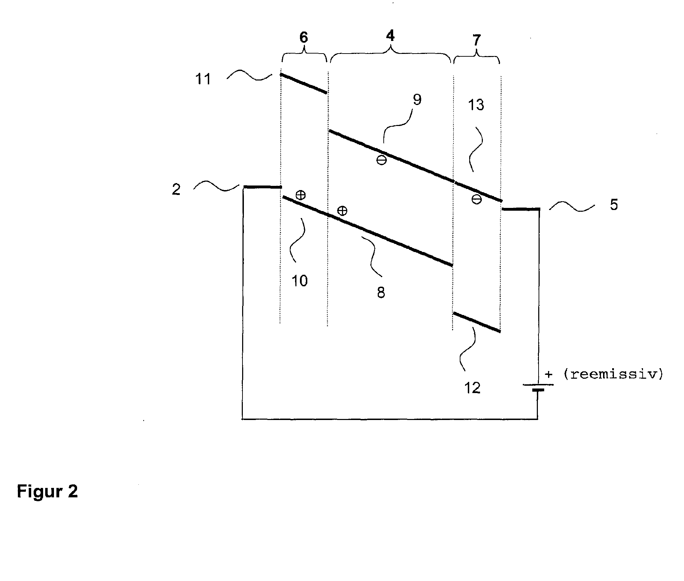

Figur 1 zeigt ein erfindungsgemäßes Display in schematischer Schnittdarstellung. Auf einem Glassubstrat 1 wird ein transparenter Kontakt 2 angeordnet. Dieser transparente Kontakt 2 bildet im emissiven Betrieb die Anode, im reemissiven Betrieb die Kathode des Displays aus. Auf der Schicht des transparenten Kontaktes 2 ist eine Elektronenblockierschicht 6 angeordnet. Auf der Elektronenblockierschicht 6 wird die organische Emitterschicht 4 und darauf eine Löcherblockierschicht 7 angeordnet. Den Abschluss bildet die Schicht 5 eines Metallkontaktes mit niedriger Austrittsarbeit. Zur Reduzierung des Dunkelstroms des Displays in Rückwärtsrichtung (während des reemissiven Betriebs), sind die Materialien der Emitterschicht 4, der Elektronenblockierschicht 6 und der Löcherblockierschicht 7 derart gewählt, dass sich die Energieniveaus von Valenzband und Leitungsband der entsprechenden Schichten 4, 6 und 7 entsprechend Figur 2 verhalten.

Die Materialien der Elektronenblockierschicht 6, der Löcherblockierschicht 7 und der Emitterschicht 4 sind so gewählt, dass das Leitungsband 9 (niedrigstes unbesetztes Molekülorbital) der Emitterschicht 4 dem Leitungsband 13 der Löcherblockierschicht 7 und das Valenzband 8 (höchstes besetztes Molekülorbital) der Emitterschicht 4 dem Valenzband 10 der Elektronenblockierschicht 6 entspricht und weiterhin das Leitungsband 11 der Elektronenblockierschicht 6 energetisch höher ist als das Leitungsband 9 der Emitterschicht 4 und das Valenzband 8 der Emitterschicht 4 energetisch höher ist als das Valenzband 12 der Löcherblockierschicht 7. Durch diese Anpassung wird es möglich, dass in der Emitterschicht 4 erzeugte Ladungsträger ohne Barrieren abfließen können. Hierdurch wird sowohl ein emissiver als auch ein reemissiver Betrieb des Displays ermöglicht.

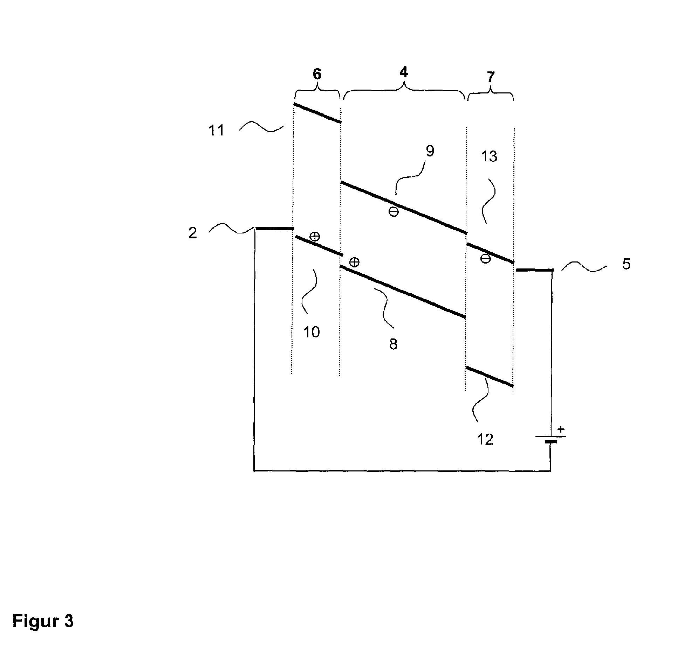

Wird das Display lediglich in einer Applikation für den reemissiven Betrieb benötigt, kann es erfindungsgemäß auch vorgesehen sein, dass das Leitungsband 9 der Emitterschicht energetisch höher als das Leitungsband 13 der Löcherblockierschicht 7 und das Valenzband 10 der Elektronenblockierschicht 6 energetisch höher als das Valenzband 8 der Emitterschicht 4 ausgebildet ist, wie in Fig. 3 schematisch dargestellt ist. In diesem Fall ist kein Vorwärtsbetrieb aufgrund der entstandenen Barrieren möglich. In diesem Ausführungsbeispiel ist die Auswahl der Materialien für die Schicht des Metallkontaktes 5 nicht auf unedle Metalle begrenzt, so dass auch Materialien mit verbesserter Korrosionsbeständigkeit verwendet werden können. Hierdurch wird es ebenfalls möglich, invertierte Schichtstrukturen herzustellen, bei denen der transparente Kontakt die Rolle des Metallkontaktes übernimmt und zur Extraktion von Elektronen dient. Der transparente Kontakt wird dann im reemissiven Betrieb positiv gegenüber dem Metallkontakt gepolt, ohne dass eine Ladungsträgerinjektion stattfindet.

Als Materialien für Elektronenblockierschicht 6 und Löcherblockierschicht 7 können organische Materialien mit Pi-konjugierten Elektronensystemen verwendet werden, bei denen die Lage der entsprechenden Energieniveaus durch die Auswahl der Molekülstruktur bestimmt wird. Geeignete Materialklassen für die Elektronenblockierschicht 6 sind unter anderem Derivate von Triphenylamin, Benzidin und Phenylendiamin. Geeignete Materialklassen für die Löcherblockierschicht 7 umfassen Oxadiazole, Oxazole, Triazole, Chinoxaline sowie Derivate von Napthalincarbonsäureimid sowie Napthalindicarbonsäurediimid. Die Materialien können sowohl niedermolekular sein als auch polymerer Natur. Der Umfang der Erfindung ist jedoch nicht auf diese Materialien begrenzt.

Speziell für die Löcherblockierschicht 7 können anorganische Materialien zur Anwendung kommen, die unter anderem Zinnoxid, Titanoxid und Zinkoxid umfassen. Diese Materialien werden undotiert in die Schichtstruktur eingebracht und sind besonders geeignet für die Herstellung invertierter Strukturen.

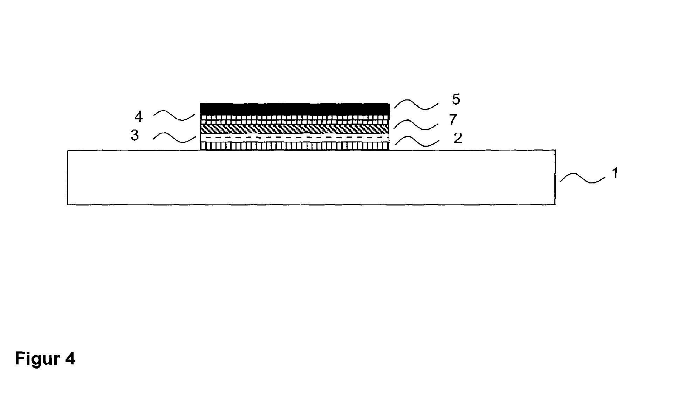

Figur 4 zeigt ein erfindungsgemäßes Display, welches lediglich für den reemissiven Betrieb vorgesehen ist.

Ausgehend von einem mit Indium-Zinnoxid (Schicht des transparenten Kontakts 2) beschichteten Glassubstrat 1 wird die Lochtransportschicht 3 mittels Aufschleudern von Poly(ethylendioxythiophen)/Polystyrolsulfonsäure mit einer Dicke im Bereich von 30-100 nm aufgebracht. Nachfolgend wird die Löscherblockierschicht 7 durch reaktives Aufdampfen im Vakuum eine Schicht von Zinnoxid SnO₂ mit einer Dicke im Bereich von 10-80 nm aufgebracht. Dazu wird Zinnoxid thermisch verdampft unter einem Druck im Bereich von 10⁻⁴ bis 10⁻³ mBar. Die Emitterschicht 4 besteht aus einem Derivat von Poly(phenylenvinylen) und wird mittels Aufschleudern aus einem organischen Lösungsmittel in einer Dicke von 30 bis 120 nm aufgebracht. Als Schicht eines Metallkontakts 5 wird eine Goldschicht mit einer Dicke von 20-100 Nanometern im Hochvakuum aufgedampft, wobei die Schicht 5 eine hohe Austrittsarbeit besitzt. Die Struktur wird vervollständigt durch eine (hier nicht dargestellte) wasser- und gasdichte Verkapselung.

Die Erfindung beschränkt sich nicht auf die hier dargestellten Ausführungsbeispiele. Vielmehr ist es möglich, durch Kombination und Modifikation der genannten Mittel und Merkmale weitere Ausführungsvarianten zu realisieren, ohne den Rahmen der Erfindung zu verlassen.

### Bezugszeichenliste

- 1: Glassubstrat
- 2: Schicht eines transparenten Kontaktes
- 3: Lochtransportschicht
- 4: Emitterschicht
- 5: Schicht eines Metallkontaktes
- 6: Elektronenblockierschicht
- 7: Löcherblockierschicht
- 8: Valenzband der Emitterschicht (höchstes besetztes Molekülorbital)
- 9: Leitungsband der Emitterschicht (niedrig besetztes Molekülorbital)
- 10: Valenzband der Elektronenblockierschicht höchstes besetztes Molekülorbital)
- 11: Leitungsband der Elektronenblockierschicht (niedrig besetztes Molekülorbital)
- 12: Valenzband der Löcherblockierschicht (höchstes besetztes Molekülorbital)
- 13: Leitungsband der Löcherblockierschicht (niedrig besetztes Molekülorbital)

## Patentansprüche

1. Display auf Basis von Photolumineszenzanzeigeelementen (PQD) bestehend aus einem Substrat (1), einer ersten Elektrodenschicht (2), welche lichtdurchlässig und auf der Frontseite der Emitterschicht (4) angeordnet ist, einer Emitterschicht (4) und einer zweiten, Elektrodenschicht (5), welche auf der Rückseite der Emitterschicht (4) angeordnet ist,
**dadurch gekennzeichnet, dass**
das Display eine Löcherblockierschicht (7) und/oder eine Elektronenblockierschicht (6) aufweist, wobei die Löcherblockierschicht (7) und/oder die Elektronenblockierschicht (6) zwischen der Emitterschicht (4) und einer Elektrodenschicht (2, 5) angeordnet sind und
das höchste besetzte Molekülorbital (12) der Löcherblockierschicht (7) energetisch niedriger als das höchste besetzte Molekülorbital (8) der Emitterschicht (4) ist und/oder
das niedrigste unbesetzte Molekülorbital (11) der Elektronenblockierschicht (6) energetisch höher als das niedrigste unbesetzte Molekülorbital (9) der Emitterschicht (4) ist.

2. Display nach Anspruch 1, **dadurch gekennzeichnet, dass** das niedrigste unbesetzte Molekülorbital (9) der Emitterschicht (4) dem niedrigsten unbesetzten Molekülorbital (13) der Löcherblockierschicht (7) entspricht und/oder das höchste besetzte Molekülorbital (10) der Elektronenblockierschicht (6) dem höchsten besetzten Molekülorbital (8) der Emitterschicht (4) entspricht, wobei die erste Elektrodenschicht (2) die Kathode und die zweite Elektrodenschicht (5) die Anode beim reemissiven Betrieb und die erste Elektrodenschicht (2) die Anode und die zweite Elektrodenschicht (5) die Kathode beim reemissiven Betrieb des Displays ausbilden.

3. Display nach Anspruch 1, **dadurch gekennzeichnet, dass** das niedrigste unbesetzte Molekülorbital (9) der Emitterschicht (4) energetisch höher als das niedrigste unbesetzte Molekülorbital (13) der Löcherblockierschicht (7) ist und/oder das höchste besetzte Molekülorbital (10) der Elektronenblockierschicht (6) energetisch höher als das höchste besetzte Molekülorbital (8) der Emitterschicht (4) ist, wobei die erste Elektrodenschicht (2) die Kathode und die zweite Elektrodenschicht (5) die Anode beim reemissiven Betrieb des Displays ausbildet.

4. Display nach einem der vorhergehenden Ansprüche, **dadurch gekennzeichnet, dass** der energetische Abstand zwischen dem höchsten besetzten Molekülorbital (10) der Elektronenblockierschicht (6) und niedrigsten unbesetzten Molekülorbital (11) der Elektronenblockierschicht (6) und der energetische Abstand zwischen dem höchsten besetzten Molekülorbital (12) der Löcherblockierschicht (7) und dem niedrigsten unbesetzten Molekülorbital (13) der Löcherblockierschicht (7) mindestens 3.3 eV beträgt.

5. Display nach einem der vorhergehenden Ansprüche, **dadurch gekennzeichnet, dass** die Elektronenblockierschicht (6) mindestens ein Derivat von Triphenylamin, Benzidin und/oder Phenylendiamin aufweist.

6. Display nach einem der vorhergehenden Ansprüche, **dadurch gekennzeichnet, dass** die Löcherblockierschicht (7) mindestens eine Verbindung der Materialklassen der Oxadiazole, Oxazole, Triazole, Chinoxaline und/oder mindestens ein Derivat von Napthalincarbonsäureimid und/oder Napthalindicarbon-säurediimid und/oder Zinnoxid, Titanoxid und/oder Zinkoxid aufweist.

7. Display nach einem der vorhergehenden Ansprüche, **dadurch gekennzeichnet, dass** die Löcherblockierschicht (7) auf der dem Substrat (1) zugewandten Seite der Emitterschicht (4) und die Elektronenblockierschicht (6) auf der dem Substrat (1) abgewandten Seite der Emitterschicht (4) angeordnet ist.

8. Photolumineszenzanzeigeelement (PQD), bestehend aus einer ersten Elektrode, welche lichtdurchlässig und auf der Frontseite des organischen Materials angeordnet ist, organischem, lichtemittierenden Material und einer zweiten Elektrode, welche auf der Rückseite des organischen Materials angeordnet ist, **dadurch gekennzeichnet, dass** das PQD eine Löcherblockierschicht und/oder eine Elektronenblockierschicht aufweist, wobei die Löcherblockierschicht und/oder die Elektronenblockierschicht zwischen dem lichtemittierenden Material und einer Elektrode angeordnet sind und
das höchste besetzte Molekülorbital der Löcherblockierschicht energetisch niedriger als das höchste besetzte Molekülorbital des lichtemittierenden Materials ist und/oder
das niedrigste unbesetzte Molekülorbital der Elektronenblockierschicht energetisch höher als das niedrigste unbesetzte Molekülorbital des lichtemittierenden Materials ist.

9. PQD nach Anspruch 8, **dadurch gekennzeichnet, dass** das niedrigste unbesetzte Molekülorbital des lichtemittierenden Materials dem niedrigsten unbesetzten Molekülorbital der Löcherblockierschicht entspricht und/oder das höchste besetzte Molekülorbital der Elektronenblockierschicht dem höchsten besetzten Molekülorbital des lichtemittierenden Materials entspricht, wobei die erste Elektrode die Kathode und die zweite Elektrode die Anode beim reemissiven Betrieb und die erste Elektrode die Anode und die zweite Elektrode die Kathode beim reemissiven Betrieb des PQD ausbilden.

10. PQD nach Anspruch 8, **dadurch gekennzeichnet, dass** das niedrigste unbesetzte Molekülorbital des lichtemittierenden Materials energetisch höher als niedrigste unbesetzte Molekülorbital der Löcherblockierschicht ist und/oder das höchste besetzte Molekülorbital der Elektronenblockierschicht energetisch höher als das höchste besetzte Molekülorbital des lichtemittierenden Materials ist, wobei die erste Elektrode die Kathode und die zweite Elektrode die Anode beim reemissiven Betrieb des Displays ausbildet.

11. PQD nach einem der Ansprüche 8 bis 10, **dadurch gekennzeichnet, dass** der energetische Abstand zwischen dem höchsten besetzten Molekülorbital der Elektronenblockierschicht und niedrigsten unbesetzten Molekülorbital der Elektronenblockierschicht und der energetische Abstand zwischen dem höchsten besetzten Molekülorbital der Löcherblockierschicht und niedrigsten unbesetzten Molekülorbital der Löcherblockierschicht mindestens 3.3 eV beträgt.

12. PQD nach einem der Ansprüche 8 bis 11, **dadurch gekennzeichnet, dass** die Elektronenblockierschicht mindestens ein Derivat von Triphenylamin, Benzidin und/oder Phenylendiamin aufweist und die Löcherblockierschicht mindestens eine Verbindung der Materialklassen der Oxadiazole, Oxazole, Triazole, Chinoxaline und/oder mindestens ein Derivat von Napthalincarbonsäureimid und/oder Napthalindicarbonsäurediimid und/oder Zinnoxid, Titanoxid und/oder Zinkoxid aufweist.

13. Verfahren zur Umwandlung von Signalspannungen in optische Bildinformationen mittels eines Displays auf Basis von Photolumineszenzanzeigeelementen (PQD), welche in einem reemissiven Modus zur Unterdrückung einer Photolumineszenzemission schaltbar sind, **dadurch gekennzeichnet, dass** die Bewegung der an der Kathode frei beweglichen Elektronen mittels einer Elektronenblockierschicht in Richtung der Anode verhindert wird und/oder
die Bewegung der an der Anode befindlichen Regionen mit Elektronenmangel mittels einer Löcherblockierschicht in Richtung der Kathode verhindert wird.
